# EUROPÄISCHE PATENTSCHRIFT

(11) **EP 2 318 303 B1**
(45) Veröffentlichungstag und Bekanntmachung des Hinweises auf die Patenterteilung: **11.12.2013**
(21) Anmeldenummer: 09779758.3
(22) Anmeldetag: 15.06.2009
(51) Int. Cl.: B81B 3/00, H02N 1/00

(54) **MIKROMECHANISCHE STRUKTUR SOWIE VERFAHREN ZUM EINSTELLEN DER ARBEITSSPALTBREITE EINER MIKROMECHANISCHEN STRUKTUR**
MICROMECHANICAL STRUCTURE AND METHOD FOR SETTING THE WORKING GAP WIDTH OF A MICROMECHANICAL STRUCTURE
STRUCTURE MICROMÉCANIQUE ET PROCÉDÉ DE RÉGLAGE DE LA LARGEUR DE L'ESPACE DE TRAVAIL D'UNE STRUCTURE MICROMÉCANIQUE

(30) Priorität: 30.07.2008 DE 102008040854
(43) Veröffentlichungstag der Anmeldung: 11.05.2011
(73) Patentinhaber: Robert Bosch GmbH, 70442 Stuttgart (DE)
(72) Erfinder: FRIEDRICH, Thomas, 72513 Hettingen (DE); MEISEL, Daniel, Christoph, 71665 Vaihingen An Der Enz (DE); RAUDZIS, Carsten, 72636 Frickenhausen (DE)
(86) Internationale Anmeldenummer: PCT/EP2009/057387
(87) Internationale Veröffentlichungsnummer: WO 2010/012541

(56) Entgegenhaltungen:
- US-A1- 2007 188 153

## Beschreibung

### Stand der Technik

Die Erfindung betrifft eine mikromechanische Struktur gemäß dem Oberbegriff des Anspruchs 1, sowie ein Verfahren zum Einstellen der Arbeitsspaltbreite einer mikromechanischen Struktur gemäß dem Oberbegriff des Anspruchs 10.

Für eine Vielzahl von Anwendungen in der Mikrosystemtechnik ist es erforderlich, in Halbleitersubstraten Arbeitsspalte mit einem hohen Aspektverhältnis, d.h. einem großen Quotienten von Spalttiefe zu Spaltbreite zu realisieren. Aus der US 6,136,630 und der DE 198 52 878 sind Lösungen bekannt, das Aspektverhältnis zu vergrößern.

In der WO 03/043189 ist ein elektromechanischer Resonator mit einer mikromechanischen Struktur beschrieben. Durch Anlegen eines elektrischen Feldes wird ein bewegliches Strukturelement gegen ein feststehendes Strukturelement zur Verkleinerung der Arbeitsspaltbreite vorgespannt.

Aus der DE 10 2004 053 103 A1 ist es bekannt, die Spaltbreite durch den Einsatz mindestens einer Feder zu verkleinern, wobei die Feder an einer Einspannstelle befestigt ist und über eine innere Vorspannung verfügt, die aus einer Beschichtung des Grundmaterials der Feder resultiert und in eine Längenänderung zwecks Spaltbreitenminimierung freigesetzt wird.

Aus der US 2007/188153 A1 ist ein mechanisch-elektrischer Energiewandler bekannt, bei dem eine räumlich fest angeordnete Elektrode und eine mobil angeordnete Elektrode gegenüber vibrieren können, wobei stets ein Abstand zwischen beiden Elektroden verbleibt.

Bei mikromechanischen Sensoren oder Aktoren, bei denen prozessbedingt kleine und einheitliche Arbeitsspaltbreiten vorliegen, ergeben sich im Wesentlichen zwei Schwierigkeiten. So ist bei als Kammantrieb ausgebildeten mikromechanischen Strukturen bei einheitlichen Spaltbreiten ein nicht lineares und somit instabiles Verhalten zu beobachten. Des Weiteren ist bei bekannten Sensoren und Aktoren mit geringster Spaltbreite problematisch, dass lediglich eine geringe mechanische Arbeitsamplitude bei Beschleunigungs- und Drehratensensoren erreicht werden kann.

### Offenbarung der Erfindung

### Technische Aufgabe

Der Erfindung liegt die Aufgabe zugrunde, eine alternative mikromechanische Struktur vorzuschlagen, mit der vergleichsweise große mechanische Arbeitsamplituden realisierbar sind. Ferner besteht die Aufgabe darin, ein entsprechend optimiertes Verfahren zur Vergrößerung der Arbeitsamplitude vorzuschlagen.

### Technische Lösung

Diese Aufgabe wird hinsichtlich der mikromechanischen Struktur mit den Merkmalen des Anspruchs 1 und hinsichtlich des Verfahrens mit den Merkmalen des Anspruchs 10 gelöst. Vorteilhafte Weiterbildungen der Erfindung sind in den Unteransprüchen angegeben. In den Rahmen der Erfindung fallen sämtliche Kombinationen aus zumindest zwei von in der Beschreibung, den Ansprüchen und/oder den Figuren offenbarten Merkmalen. Zur Vermeidung von Wiederholungen sollen verfahrensgemäß offenbarte Merkmale als vorrichtungsgemäß offenbart gelten und beanspruchbar sein. Ebenso sollen vorrichtungsgemäß offenbarte Merkmale als verfahrensgemäß offenbart gelten und beanspruchbar sein.

Der Erfindung liegt der Gedanke zugrunde, eine mikromechanische Struktur vorzuschlagen, bei der der Arbeitsspalt (Arbeitsgraben) nicht wie im Stand der Technik nach der Einbringung des Arbeitsspaltes in ein Halbleitermaterial, insbesondere durch einen Ätzprozess, zu verkleinern, sondern stattdessen die Spaltbreite durch geeignete Mittel zu vergrößern. Dabei wird bei einer nach dem Konzept der Erfindung ausgebildeten mikromechanischen Struktur der während des Betriebs der mikromechanischen Struktur, in Bezug auf einen Bezugspunkt feststehende (Halbleiter-)Strukturabschnitt relativ zu dem während des Betriebs der mikromechanischen Struktur, relativ zu dem Bezugspunkt verstellbaren (Halbleiter-)Strukturabschnitt verstellt. Hierdurch kann, insbesondere bei Beschleunigungs- und Drehratensensoren, aber auch bei Aktoren im Nachhinein eine große mechanische Arbeits-Amplitude realisiert werden. Auch ist es bei entsprechender Ausbildung der mikromechanischen Struktur, wie später noch erläutert werden wird, möglich, durch die Realisierung uneinheitlicher Spaltbreiten ein lineares Verhalten eines entsprechenden, insbesondere kammartig strukturierten, Aktors oder Sensors zu realisieren. Der Bezugspunkt kann entweder selbst beweglich oder feststehend angeordnet werden. Bevorzugt ist der Bezugspunkt Bestandteil einer mit der erfindungsgemäßen Mikrostruktur ausgestatteten Vorrichtung. Beilspielsweise kann der Bezugspunkt von einem relativ zu einem Sensorgehäuse verdrehbar gelagerten Rahmen eines Drehrahmensensors gebildet werden.

Zusammenfassend liegt der Kern der Erfindung also darin, den funktionsrelevanten Arbeitsspalt bei mikromechanischen Strukturen nach der Spaltherstellung zu vergrößern. Unter einem Arbeitsspalt im Sinne der Erfindung wird bei einer als Aktor dienenden mikromechanischen Struktur der Spalt verstanden, in den der bewegliche (aktiv verstellbare) Strukturabschnitt hineinverstellt wird. Bei einem Sensor wird unter einem Arbeitsspalt der Spalt verstanden, der von Strukturabschnitten begrenzt wird, zwischen denen eine elektrische Kapazität gemessen wird. Dabei nimmt die Kapazität bei kleiner werdendem Arbeitsspalt durch Verstellen des verstellbaren Strukturabschnittes in Richtung des feststehenden Strukturabschnittes zu.

In Weiterbildung der Erfindung ist mit Vorteil vorgesehen, dass die Mittel den Arbeitsspalt derart verbreitern, dass der Arbeitsspalt eine uneinheitliche Spaltbreite aufweist. Anders ausgedrückt wird durch eine zumindest abschnittsweise Verbreiterung des Arbeitsspaltes eine unterschiedliche Spaltbreite an mindestens zwei unterschiedlichen Stellen des Arbeitsspaltes und damit ein lineares Verhalten realisiert. Bei einem Kammantrieb sind dabei vorzugsweise die sich in Richtung der Längserstreckung des Kammantriebes erstreckenden Arbeitsspaltabschnitte breiter (quer zur Längserstreckung) als die sich quer zur Längserstreckung des Kammantriebs erstreckenden Arbeitsspaltabschnitte.

Gemäß einer einfachsten Ausführungsform wird der Arbeitsspalt lediglich eindimensional, also durch Verstellen mindestens eines Strukturabschnittes in eine einzige Richtung verbreitert. Es ist jedoch auch eine Ausführungsform realisierbar, insbesondere bei einem nicht gerade, sondern beispielsweise über mindestens ein Eck verlaufenden Arbeitsspalt, bei der der Arbeitsspalt zweidimensional verbreitert wird, insbesondere durch Verstellen mindestens eines im Betrieb der mikromechanischen Struktur feststehenden Strukturabschnittes in zwei Richtungen, oder bevorzugt durch Verstellen mindestens zweier oder mehrerer Strukturelemente in zwei, vorzugsweise rechtwinklig zueinander verlaufenden, Richtungen.

Im Hinblick auf die Ausbildung der Mittel zum Verbreitern des Arbeitsspaltes gibt es unterschiedliche Möglichkeiten. Vom Grundsatz her ist es denkbar, die gleichen Mittel (jedoch mit umgekehrter Wirkung) einzusetzen, wie sie im Stand der Technik zur Verschmälerung des Arbeitsspaltes eingesetzt werden. Ganz besonders bevorzugt ist eine Ausführungsform, bei der die Mittel den Arbeitsspalt durch Erzeugen eines elektromagnetischen Feldes, also durch den Einsatz elektrostatischer Kräfte, verbreiternd ausgebildet sind. Zusätzlich oder alternativ können die Mittel den Arbeitsspalt durch den Einsatz mindestens einer Feder verbreiternd ausgebildet sein. Ganz besonders bevorzugt ist dabei eine Ausführungsform, bei der die Feder in einer Art wie in der DE 10 2004 058 103 A1 beschrieben ausgebildet ist, die Feder also mit einer Beschichtung versehen ist, die für eine innere Vorspannung der Feder sorgt.

Um genügend Raum innerhalb der mikromechanischen Struktur zur Vergrößerung des Arbeitsspaltes bereitzustellen, ist eine Ausführungsform bevorzugt, bei der dem mindestens einen zu verbreiternden Arbeitsspalt mindestens ein Hilfsspalt zugeordnet ist, der mit Hilfe der Mittel zum Verbreitern des Arbeitsspaltes verschmälert, insbesondere vollständig geschlossen wird. Ganz besonders bevorzugt ist dabei eine Ausführungsform, bei der der Hilfsspalt parallel zum Arbeitsspalt verläuft.

Gemäß einer besonders bevorzugten Ausführungsform der mikromechanischen Struktur sind die den Arbeitsspalt begrenzenden Strukturabschnitte kammförmig ausgebildet, wobei die kammartigen Strukturabschnitte mit Abstand zueinander verzahnungsartig ineinandergreifen. Zum Vergrößern des Arbeitsspaltes wird derjenige Strukturabschnitt von dem jeweils anderen Strukturabschnitt weg verstellt, der im Betrieb der mikromechanischen Struktur fest steht. Besonders bevorzugt wird der Arbeitsspalt dabei nur eindimensional vergrößert, vorzugsweise derart, dass die anfänglich erwähnten uneinheitlichen Arbeitsspaltbreiten realisiert werden.

In Weiterbildung der Erfindung ist mit Vorteil vorgesehen, dass der Arbeitsspalt als um den im Betrieb der mikromechanischen Struktur feststehenden Strukturabschnitt umlaufender (ringförmiger) Spalt ausgebildet ist. Bevorzugt sind mehrere, insbesondere vier, im Betrieb feststehende Strukturabschnitte vorgesehen, die mit Hilfe der Mittel zum Verbreitern des Arbeitsspaltes aufeinander zu bewegt werden, um den Arbeitsspalt, vorzugsweise gleichmäßig, zu verbreitern.

Ganz besonders bevorzugt ist eine Ausführungsform, bei der der Arbeitsspalt durch Parallelverstellen mehrerer, während des Betriebs der mikromechanischen Struktur feststehender Strukturabschnitte verbreitert wird. Hierbei ist bevorzugt jedem zu verstellenden Strukturabschnitt ein Hilfsspalt zugeordnet, der vorzugsweise durch Verstellen der feststehenden Strukturabschnitte vollständig geschlossen wird. Die beschriebene Ausführungsform ist von besonderem Vorteil, da sich die Hilfsspaltbreiten addieren und somit eine besonders starke Verbreiterung des Arbeitsspaltes möglich ist.

Die Erfindung führt auch auf ein Verfahren zum Einstellen eines von mindestens zwei relativ zueinander verstellbaren Strukturabschnitten begrenzten Arbeitsspaltes einer mikromechanischen Struktur, insbesondere eines Sensors oder eines Aktors. Erfindungsgemäß ist vorgesehen, dass der Arbeitsspalt durch Verstellen des mindestens einen während des Betriebs der mikromechanischen Struktur feststehenden Strukturabschnittes im Nachhinein verbreitert wird. Anders ausgedrückt wird also nicht der während des Betriebs der mikromechanischen Struktur bewegliche Strukturabschnitt verstellt, sondern der feststehende Referenzstrukturabschnitt.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1: eine mikromechanische Kammstruktur unmittelbar nach der Herstellung der Arbeitsspalte im noch nicht verbreiterten Zustand,
- Fig. 2: eine mikromechanische Kammstruktur gemäß Fig. 1 nach einer nachträglichen Arbeitsspaltverbreiterung,
- Fig. 3: ein Detailausschnitt aus der mikromechanischen Kammstruktur gemäß Fig. 1,
- Fig. 4: ein Detailausschnitt aus der verbreiterten mikromechanischen Kammstruktur gemäß Fig. 2,
- Fig. 5: eine alternative mikromechanische Struktur mit einem umlaufenden Arbeitsspalt vor der Verbreiterung,
- Fig. 6: die mikromechanische Struktur gemäß Fig. 5 nach dem Verbreitern des Arbeitsspaltes,
- Fig. 7: ein weiteres, alternatives Ausführungsbeispiel einer mikromechanischen Struktur mit einem Arbeitsspalt, wobei mehrere während des Betriebs der mikromechanischen Struktur feststehende Strukturabschnitte vorgesehen sind, die durch Parallelverschieben in den in Fig. 8 gezeigten Zustand verstellbar sind und
- Fig. 8: die mikromechanische Struktur gemäß Fig. 7 mit verbreitertem Arbeitsspalt.

### Ausführungsformen der Erfindung

In den Figuren sind gleiche Elemente und Elemente mit der gleichen Funktion mit den gleichen Bezugszeichen gekennzeichnet.

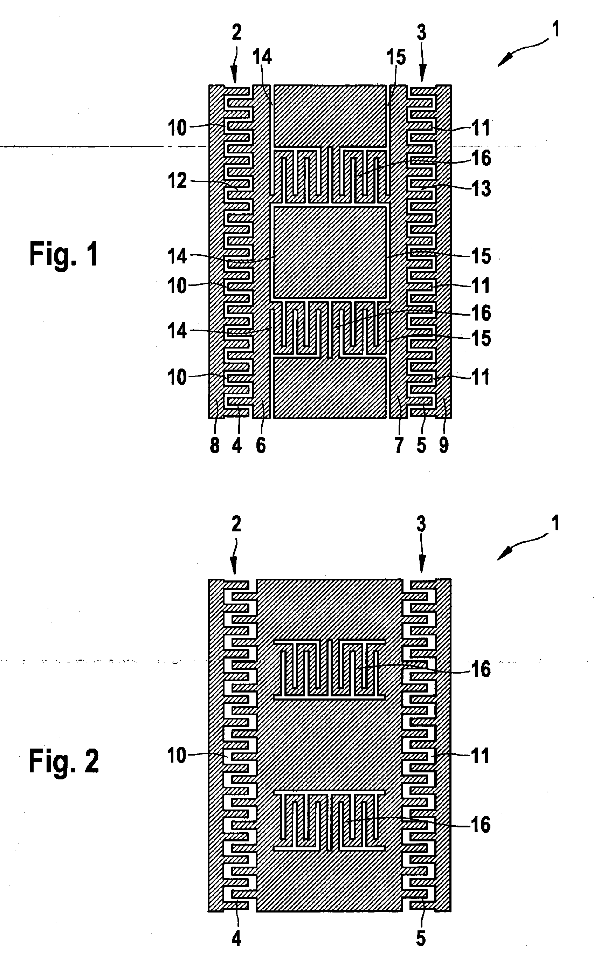

In Fig. 1 ist ein Ausschnitt einer wahlweise als Sensor oder Aktor dienenden mikromechanischen Struktur 1 gezeigt. Die mikromechanische Struktur 1 ist durch Ätzschritte im Halbleitermaterial ausgebildet. Wie sich aus Fig. 1 ergibt, umfasst die mikromechanische Struktur zwei aktive Strukturbereiche 2, 3, die jeweils einen mäanderförmigen Arbeitsspalt 4, 5 aufweisen, wobei die Arbeitsspalte 4, 5 parallel zueinander verlaufen. Jeder der Arbeitsspalte 4, 5 ist ausgebildet zwischen einem in der Zeichnungsebene inneren, kammartigen, im Betrieb der mikromechanischen Struktur 1 feststehenden Strukturabschnitt 6, 7 und einem in der Zeichnungsebene äußeren, mit dem jeweiligen feststehenden Strukturabschnitt 6, 7 verzahnten, kammartigen, beweglichen (im Falle eines Aktors aktiv verstellbaren) Strukturabschnitt 8, 9.

Die sich in Richtung der Längserstreckung der Strukturbereiche 2, 3 erstreckenden Arbeitsspaltabschnitte 10, 11 haben nach dem Ätzen der Grabenstruktur die gleiche Spaltbreite, wie die sich quer zur Längserstreckung der Strukturbereiche 2, 3 erstreckenden Arbeitsspaltabschnitte 12, 13. Zum Verbreitern der sich in Richtung der Längserstreckung der kammartigen Strukturbereiche 2, 3 erstreckenden Arbeitsspaltabschnitte 10, 11 wird ein elektrisches Feld erzeugt, derart, dass die in der Zeichnungsebene inneren, während des Betriebs der mikromechanischen Struktur 1 feststehenden Strukturabschnitte 6, 7 aufeinander zu, d.h. von-dem zugehörigen im Betrieb beweglichen Strukturabschnitt 8, 9 weg bewegt werden. Dies ist dadurch möglich, dass jedem feststehenden Strukturabschnitt 6, 7 mehrere Hilfsspalte 14, 15 zugeordnet sind, die sich parallel zu den sich in Richtung der Längserstreckung der Strukturbereiche 2, 3 erstreckenden Arbeitsspaltabschnitten 10, 11 erstrecken. Die Hilfsspalte 14, 15 sind ausgebildet innerhalb eines Federelementes 16. Zusätzlich oder alternativ zum Erzeugen eines elektrischen Feldes kann auch ein mechanischer, federkraftunterstützter Verstellmechanismus realisiert werden. Die Hilfsspalte 14, 15 werden durch Verstellen der Strukturabschnitte 6, 7 nach innen verschlossen, sodass die in Fig. 2 gezeigte mikromechanische Struktur 1 resultiert, bei der die Arbeitsspalte 4, 5, genauer die sich in Richtung der Längserstreckung der Strukturbereiche 2, 3 erstreckenden Arbeitsspaltabschnitte 10, 11 in Richtung quer zur Längserstreckung der Strukturbereiche 2, 3 verbreitert sind, wodurch eine größere mechanische Amplitude und in dem gezeigten Ausführungsbeispiel auch ein lineares Verhalten gewährleistet wird.

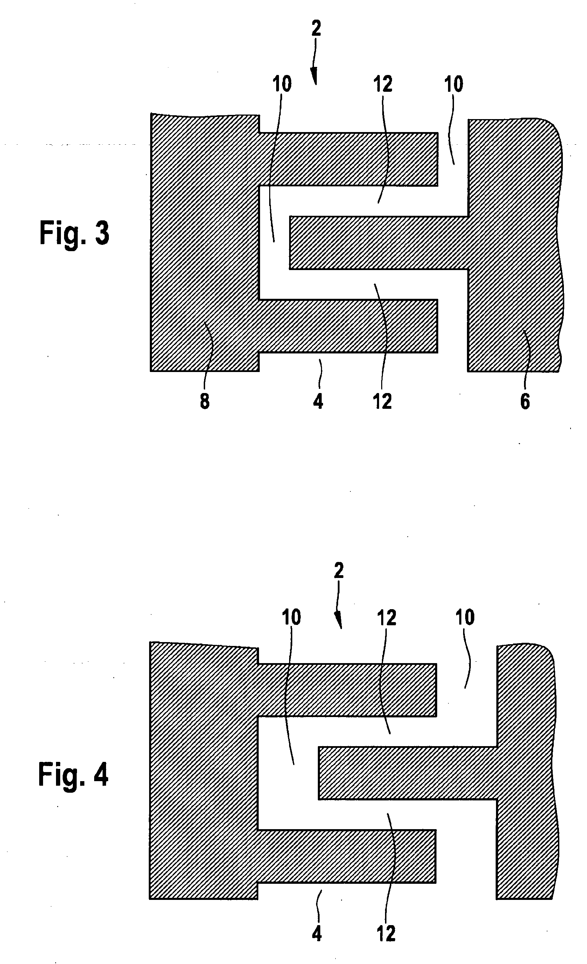

In den Fig. 3 und 4 ist ein Ausschnitt des Arbeitsspaltes 4 gemäß den Fig. 1 bzw. 2 vor bzw. nach der nachträglichen Arbeitsspaltverbreiterung gezeigt. Zu erkennen ist, dass der Arbeitsspalt 4 vor der Verbreiterung eine einheitliche Spaltbreite, von hier 1,5µm, aufweist. Anders ausgedrückt ist die Spaltbreite der sich in Richtung der Längserstreckung des Strukturbereichs 2 erstreckenden Arbeitsspaltabschnittes 10 vor dem Verbreitern genauso groß wie die Breite der sich quer hierzu erstreckenden Arbeitsspaltabschnitte 12. Durch Verstellen des während des Betriebs feststehenden Strukturabschnittes 6 in der Zeichnungsebene nach rechts wird der Arbeitsspaltabschnitt 10 verbreitert, wohingegen die Breite der Arbeitsspaltabschnitte 12 konstant bleibt. In dem in Fig. 4 gezeigten Ausführungsbeispiel ist die Spaltbreite des Arbeitsspaltabschnittes 10 doppelt so groß wie die Spaltbreite des Arbeitsspaltes 12.

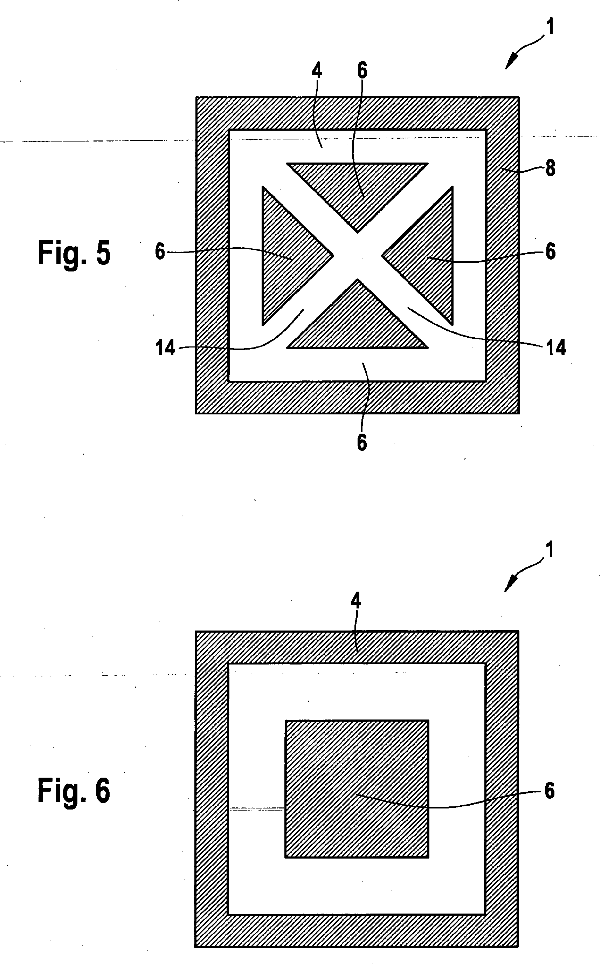

In den Fig. 5 und 6 ist ein alternatives Ausführungsbeispiel einer mikromechanischen Struktur 1 vor bzw. nach der Verbreiterung des hier als umlaufender Spalt ausgebildeten Arbeitsspaltes 4 gezeigt. Die mikromechanische Struktur 1 umfasst einen äußeren Strukturabschnitt 8 und vier dreieckig konturierte, während des Betriebs der mikromechanischen Struktur 1 feststehende Strukturabschnitte 6, zwischen denen schräg verlaufende, sich kreuzende Hilfsspalte 14 realisiert sind. Diese werden durch Relativverstellen der Strukturabschnitte 6 geschlossen, woraus eine zweidimensionale Vergrößerung des umlaufenden Arbeitsspaltes 4 resultiert, wie sie in Fig. 6 gezeigt ist. Der Mechanismus zum Verstellen der Strukturabschnitte 6 kann beispielsweise als elektrostatischer Verstellmechanismus oder als mechanischer Verstellmechanismus unter Einsatz mindestens eines Federelementes realisiert werden.

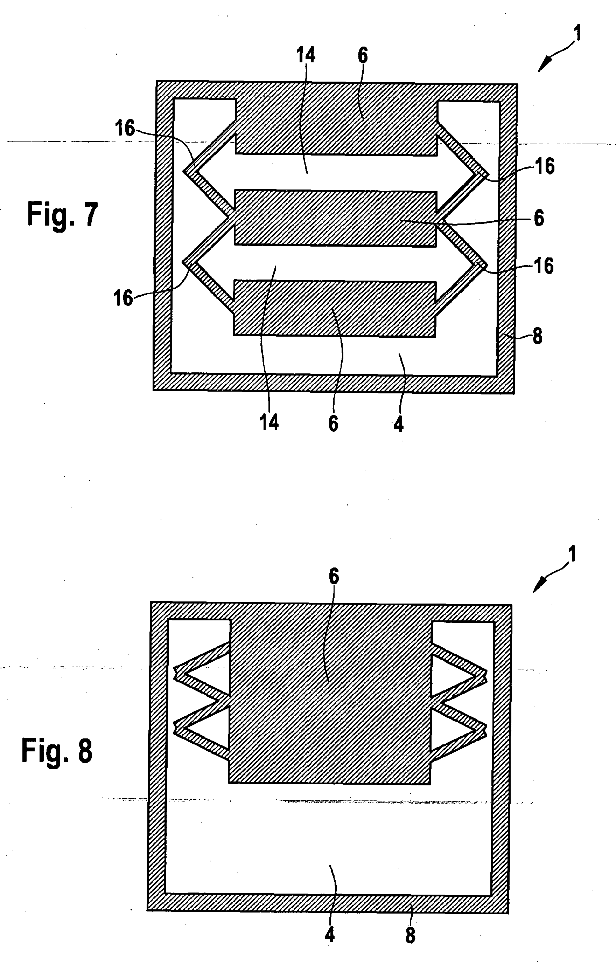

In den Fig. 7 und 8 ist ein weiteres alternatives Ausführungsbeispiel einer mikromechanischen Struktur gezeigt. Zu erkennen sind drei parallel zueinander verlaufende Strukturabschnitte 6, die während des Betriebs der mikromechanischen Struktur feststehen. Zwischen jeweils zwei benachbarten Strukturabschnitten 6 ist ein Hilfsspalt realisiert, der durch Aufeinanderzubewegen der Strukturabschnitte 6, wie sich aus Fig. 8 ergibt, geschlossen wird. Die feststehenden Strukturabschnitte 6 sind mechanisch über Federelemente 16 miteinander verbunden, die die Verstellung der Strukturabschnitte 6 bewirken. Es resultiert ein in Fig. 8 gezeigter, im Vergleich zu Fig. 7 verbreiterter Arbeitsspalt 4.

## Patentansprüche

1. Mikromechanische Struktur, insbesondere Sensor oder Aktor, mit mindestens einem von mindestens zwei relativ zueinander verstellbaren Strukturabschnitten (6, 7, 8, 9) begrenzten Arbeitsspalt (4, 5) und mit Mitteln zum Einstellen der Arbeitsspaltbreite, wobei die Mittel so ausgebildet sind, dass sie den Arbeitsspalt verbreitern durch Verstellen des mindestens einen, während des Betriebs der mikromechanischen Struktur (1) relativ zu einem Bezugspunkt feststehenden, Strukturabschnitts (6, 7) relativ zu dem, im Betrieb relativ zu diesem Bezugspunkt beweglichen, Strukturabschnitt (8, 9), **dadurch gekennzeichnet, dass** die Mittel den Arbeitsspalt (4, 5) zweidimensional verbreitern.

2. Mikromechanische Struktur nach Anspruch 1, **dadurch gekennzeichnet, dass** die Mittel den Arbeitsspalt (4, 5) derart verbreiternd ausgebildet sind, dass der Arbeitsspalt (4, 5) an mindestens zwei Stellen eine unterschiedliche Spaltbreite aufweist.

3. Mikromechanische Struktur (1) nach einem der vorhergehenden Ansprüche, **dadurch gekennzeichnet, dass** die Mittel den Arbeitsspalt (4, 5) durch Erzeugen elektrostatischer Kräfte verbreiternd ausgebildet sind.

4. Mikromechanische Struktur nach einem der vorhergehenden Ansprüche, **dadurch gekennzeichnet, dass** die Mittel den Arbeitsspalt (4, 5) mittels mindestens einer, insbesondere beschichteten, Feder verbreiternd ausgebildet sind.

5. Mikromechanische Struktur nach einem der vorhergehenden Ansprüche, **dadurch gekennzeichnet, dass** die Mittel den Arbeitsspalt (4, 5) durch verschmälern mindestens eines Hlifsspaltes (14, 15) verbreiternd ausgebildet sind.

6. Mikromechanische Struktur nach einem der vorhergehenden Ansprüche, **dadurch gekennzeichnet, dass** die den Arbeitsspalt (4, 5) begrenzenden Strukturabschnitte (6, 7, 8, 9) kammförmlg ausgebildet sind, und dass der während des Betriebs der mikromechanischen Struktur (1) feststehende Strukturabschnitt (6, 7) mit den Mitteln von dem während des Betriebs verstellbaren Strukturabschnitt weg bewegbar ist.

7. Mikromechanische Struktur nach einem der vorhergehenden Ansprüchen, **dadurch gekennzeichnet, dass** der Arbeitsspalt (4, 5) als um den mindestens einen im Betrieb feststehenden Strukturabschnitt (6, 7) umlaufender Spalt ausgebildet ist.

8. Mikromechanische Struktur nach einem der vorhergehenden Ansprüche, **dadurch gekennzeichnet, dass** der Arbeitsspalt (4, 5) durch Parallelverstellen mehrerer während des Betriebs der mikromechanischen Struktur (1) feststehender Strukturabschnitte (6, 7) verbreiterbar ist.

9. Verfahren zum Einstellen eines, von mindestens zwei relativ zueinander verstellbaren Strukturabschnitten (6, 7, 8, 9) begrenzten Arbeitsspaltes (4, 5) einer mikromechanischen Struktur (1), insbesondere eines Sensors oder eines Aktors, wobei der Arbeitsspalt (4, 5) durch Verstellen des mindestens einen, während des Betriebs der mikromechanischen Struktur (1) relativ zu einem Bezugspunkt feststehenden, Strukturabschnitts (6, 7) relativ zu einem, relativ zu dem Bezugspunkt beweglichen, Strukturabschnitt (8, 9) verbreitert wird, **dadurch gekennzeichnet, dass** die Mittel den Arbeitsspalt (4, 5) zweidimensional verbreitern.

## Claims

1. Micromechanical structure, in particular a sensor or actuator, having at least one working gap (4, 5), which is bounded by at least two structure sections (6, 7, 8, 9) which can be moved relative to one another, and having means for setting the working gap width, the means being designed such that they broaden the working gap by movement of the at least one structure section (6, 7), which is stationary relative to a reference point during operation of the micromechanical structure (1), relative to the structure section (8, 9), which moves relative to this reference point during operation, **characterized in that** the means broaden the working gap (4, 5) two-dimensionally.

2. Micromechanical structure according to Claim 1, **characterized in that** the means are designed to broaden the working gap (4, 5) such that the working gap (4, 5) has a different gap width at at least two points.

3. Micromechanical structure (1) according to one of the preceding claims, **characterized in that** the means are designed to broaden the working gap (4, 5) by production of electrostatic forces.

4. Micromechanical structure according to one of the preceding claims, **characterized in that** the means are designed to broaden the working gap (4, 5) by means of at least one, in particular coated, spring.

5. Micromechanical structure according to one of the preceding claims, **characterized in that** the means are designed to broaden the working gap (4, 5) by narrowing at least one auxiliary gap (14, 15).

6. Micromechanical structure according to one of the preceding claims, **characterized in that** the structure sections (6, 7, 8, 9) which bound the working gap (4, 5) are in the form of combs, and **in that** the structure section (6, 7) which is stationary during operation of the micromechanical structure (1) can be moved away from the structure section which can be moved during operation, by the means.

7. Micromechanical structure according to one of the preceding claims, **characterized in that** the working gap (4, 5) is in the form of a gap which runs around the at least one structure section (6, 7) which is stationary during operation.

8. Micromechanical structure according to one of the preceding claims, **characterized in that** the working gap (4, 5) can be broadened by parallel movement of a plurality of structure sections (6, 7) which are stationary during operation of the micromechanical structure (1).

9. Method for setting a working gap (4, 5), which is bounded by at least two structure sections (6, 7, 8, 9) which can be moved relative to one another, of a micromechanical structure (1), in particular of a sensor or of an actuator, the working gap (4, 5) being broadened by movement of the at least one structure section (6, 7), which is stationary relative to a reference point during operation of the micromechanical structure (1), relative to a structure section (8, 9), which moves relative to the reference point, **characterized in that** the means broaden the working gap (4, 5) two-dimensionally.

## Revendications

1. Structure micromécanique, en particulier capteur ou actionneur, comprenant au moins une fente de travail (4, 5) délimitée par au moins deux sections de structure réglables l'une par rapport à l'autre (6, 7, 8, 9) et des moyens d'ajustement de la largeur de la fente de travail, les moyens étant réalisés de manière à élargir la fente de travail par réglage de l'au moins une section de structure (6, 7) fixe par rapport à un point de référence pendant le fonctionnement de la structure micromécanique (1), par rapport à la section de structure (8, 9) déplaçable par rapport à ce point de référence pendant le fonctionnement, **caractérisée en ce que** les moyens élargissent la fente de travail (4, 5) de manière bidimensionnelle.

2. Structure micromécanique selon la revendication 1, **caractérisée en ce que**
les moyens sont réalisés de manière à élargir la fente de travail (4, 5) de telle sorte que la fente de travail (4, 5) présente, en au moins deux endroits, une largeur de fente différente.

3. Structure micromécanique (1) selon l'une quelconque des revendications précédentes,
**caractérisée en ce que**
les moyens sont réalisés de manière à élargir la fente de travail (4, 5) par génération de forces électrostatiques.

4. Structure micromécanique selon l'une quelconque des revendications précédentes,
**caractérisée en ce que**
les moyens sont réalisés de manière à élargir la fente de travail (4, 5) au moyen d'au moins un ressort, en particulier revêtu.

5. Structure micromécanique selon l'une quelconque des revendications précédentes,
**caractérisée en ce que**
les moyens sont réalisés de manière à élargir la fente de travail (4, 5) par rétrécissement d'au moins une fente auxiliaire (14, 15).

6. Structure micromécanique selon l'une quelconque des revendications précédentes,
**caractérisée en ce que**
les sections de structure (6, 7, 8, 9) limitant la fente de travail (4, 5) sont réalisées en forme de peigne, et **en ce que** la section de structure (6, 7) fixe pendant le fonctionnement de la structure micromécanique (1) peut être déplacée par les moyens à l'écart de la section de structure déplaçable pendant le fonctionnement.

7. Structure micromécanique selon l'une quelconque des revendications précédentes,
**caractérisée en ce que**
la fente de travail (4, 5) est réalisée sous forme de fente périphérique s'étendant autour de l'au moins une section de structure (6, 7) fixe pendant le fonctionnement.

8. Structure micromécanique selon l'une quelconque des revendications précédentes,
**caractérisée en ce que**
la fente de travail (4, 5) peut être élargie par disposition en parallèle de plusieurs sections de structure (6, 7) fixes pendant le fonctionnement de la structure micromécanique (1).

9. Procédé d'ajustement d'une fente de travail (4, 5) d'une structure micromécanique (1) délimitée par au moins deux sections de structure (6, 7, 8, 9) réglables l'une par rapport à l'autre, en particulier d'un capteur ou d'un actionneur, la fente de travail (4, 5) étant élargie par réglage de l'au moins une section de structure (6, 7) fixe par rapport à un point de référence pendant le fonctionnement de la structure micromécanique (1), par rapport à une section de structure (8, 9) déplaçable par rapport au point de référence, **caractérisé en ce que** les moyens élargissent la fente de travail (4, 5) de manière bidimensionnelle.
